# FASCICULE DE BREVET EUROPEEN

(11) **EP 1 929 630 B1**
(45) Date de publication et mention de la délivrance du brevet: **19.04.2017**
(21) Numéro de dépôt: 06793078.4
(22) Date de dépôt: 30.08.2006
(51) Int. Cl.: H03K 17/041, H02M 1/08

(54) **COMMANDE RAPPROCHEE DE CONVERTISSEURS D'ENERGIE ELECTRIQUES**
STRIKTE STEUERUNG ELEKTRISCHER STROMUMSETZER
CLOSE CONTROL OF ELECTRIC POWER CONVERTERS

(30) Priorité: 09.09.2005 FR 0509225
(43) Date de publication de la demande: 11.06.2008
(73) Titulaire: THALES, 92400 Courbevoie (FR)
(72) Inventeur: THOMAS, Philippe, F-94150 Rungis (FR); JAROUSSE, Jean-Michel, F-92340 Bourg La Reine (FR); LABOURE, Eric, F-94230 Cachan (FR)
(74) Mandataire: Lucas, Laurent Jacques
(86) Numéro de dépôt international: PCT/EP2006/065834
(87) Numéro de publication internationale: WO 2007/028745

(56) Documents cités:
- EP-A- 1 063 771
- DE-A1- 4 441 492
- US-A- 5 438 294
- US-A- 5 959 438
- US-A1- 2003 063 482
- JOYCE J M ET AL: "Current-Mode Regenerative Gate Drive for Power Field-Effect Transistors" IBM TECHNICAL DISCLOSURE BULLETIN, IBM CORP. NEW YORK, US, vol. 26, no. 5, octobre 1983 (1983-10), pages 2246-2248, XP002132629 ISSN: 0018-8689

## Description

L'invention concerne une commande rapprochée de convertisseurs d'énergie électriques. En particulier, l'invention s'applique à des alimentations électriques isolées fonctionnant à haute fréquence, avec un rendement élevé et un haut niveau d'intégration. De plus, l'invention peut être utilisée pour commander des convertisseurs en pont, présents notamment dans des onduleurs.

Les alimentations électriques à découpage doivent notamment répondre à différentes contraintes d'intégration parmi lesquelles figurent les contraintes de volume, de poids ou encore de dissipation thermique. Une solution permettant de réduire le volume et le poids d'une alimentation électrique à découpage est de diminuer la surface occupée par les circuits magnétiques, et notamment le transformateur, en augmentant la fréquence de fonctionnement des circuits magnétiques.

Lorsque la fréquence de fonctionnement des circuits magnétiques devient élevée, c'est-à-dire supérieure au mégahertz, les alimentations électriques à découpage doivent alors utiliser une commande comportant des composants supportant les hautes fréquences. Cela implique d'utiliser de nouveaux types de composants, comme par exemple des transistors MOS de nouvelle génération. L'emploi de tels composants impose de repenser les schémas des circuits électriques et peuvent avoir un impact sensible sur le coût de fabrication, de production et d'industrialisation.

Une autre solution permettant d'augmenter la fréquence de fonctionnement des circuits magnétiques est l'utilisation de composants commandés en tension (composants en technologie MOS, transistor bipolaire à grille isolée,...), dont la capacité de « gate » est élevée. Cependant, cette solution engendre une augmentation de la dissipation thermique fonction de la fréquence de fonctionnement des circuits magnétiques. Il en résulte que le rendement d'une telle solution n'atteint qu'au mieux les 90%. Cette solution est inadaptée pour les alimentations de faible puissance (c'est à dire les alimentations de quelques dizaines de watts).
Une demande de brevet EP 1 063 771 A1 décrit un commutateur ultra-rapide à haute fréquence de récurrence utilisé notamment dans des convertisseurs électriques de puissance.

L'invention a notamment pour but de pallier les inconvénients précités. A cet effet, l'invention a pour objet une commande rapprochée selon la revendication 1.

Dans un mode de réalisation, le point E est connecté au point G par un condensateur C₁.

Dans un autre mode de réalisation, le point H est connecté au point C par un condensateur (C₂).

Dans un autre mode de réalisation, une diode D₃ est connectée entre le point C et le point D, l'anode de la diode D₃ étant reliée au point D, la cathode de la diode D₃ étant reliée au point C.

La commande rapprochée peut encore comporter une première diode Zener D₄ et une seconde diode Zener D₅. La cathode de la première diode Zener D₄ est alors reliée au point C. L'anode de la première diode Zener D₄ est reliée à l'anode de la seconde diode Zener D₅. La cathode de la seconde diode Zener D₅ est reliée au point D.

La commande rapprochée peut comporter un condensateur C₂ relié entre le point H et un point I, un condensateur C₃ relié entre un point 1 et un point C, une diode D₇ reliée entre le point 1 et un point J. L'anode de la diode D₇ est alors reliée au point I, la cathode de la diode D₇ est reliée au point J. Une résistance R₁ est reliée entre le point J et le point C, une diode D₈ est reliée entre le point J et le point D. L'anode de la diode D₈ est alors reliée au point D. La cathode de la diode D₈ est reliée au point J.

L'invention a notamment pour avantages qu'elle permet d'obtenir des alimentations dont le rendement est élevé. De plus, le rapport cyclique de la commande rapprochée de convertisseurs peut être choisi différent de ½_{.}

D'autres caractéristiques et avantages de l'invention apparaîtront à l'aide de la description qui suit faite en regard des dessins annexés qui représentent :
- la figure 1, un schéma de principe d'une commande rapprochée de convertisseurs selon l'invention ;
- la figure 2, un schéma de principe d'une commande rapprochée de convertisseurs selon un autre mode de réalisation de l'invention ;
- la figure 3, un schéma de principe d'une commande rapprochée de convertisseurs selon un autre mode de réalisation de l'invention ;
- la figure 4, la stratégie de commande des interrupteurs selon l'invention ;
- la figure 5, la stratégie de commande des interrupteurs I₁ et I₂ selon l'invention appliquée à une commande rapprochée de convertisseurs fonctionnant avec un rapport cyclique ½ selon l'invention.

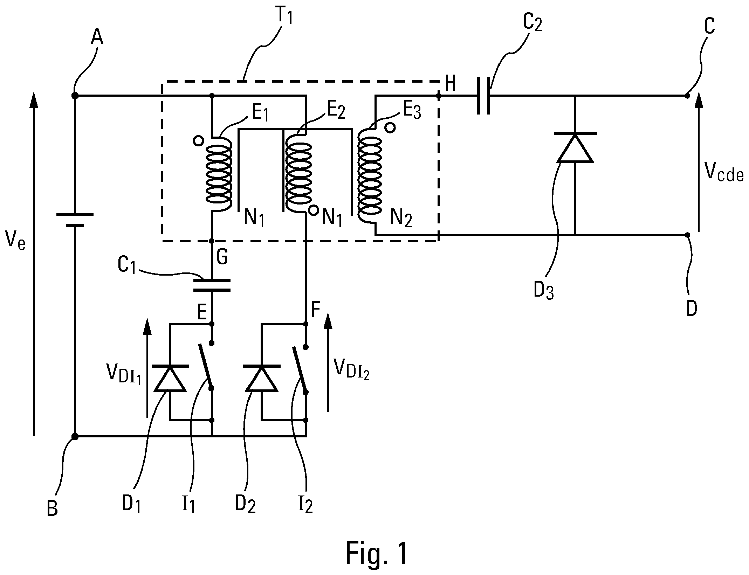

La figure 1 montre un schéma de principe d'une commande rapprochée de convertisseurs selon l'invention. La commande rapprochée de convertisseurs selon l'invention présentée à la figure 1 est un exemple de commande rapprochée pouvant par exemple être utilisée dans des alimentations électriques à découpage isolées fonctionnant à haute fréquence (c'est à dire à une fréquence supérieure à un mégahertz), dont le rendement est élevé (c'est-à-dire supérieur à 90%). De part l'ensemble de ces caractéristiques, ce type d'alimentation présente un haut niveau d'intégration par rapport aux alimentations électriques à découpage fonctionnant à plus faible fréquence. La commande rapprochée de convertisseurs selon l'invention présentée à la figure 1 est particulièrement adaptée pour être utilisée pour commander un convertisseur en pont fonctionnant autour d'un rapport cyclique de ½. La commande rapprochée de convertisseurs selon l'invention est une commande isolée permettant de récupérer l'énergie stockée dans la capacité des commandes des interrupteurs commandés en tension couramment utilisés en électronique de puissance.

La commande rapprochée de convertisseurs selon l'invention reçoit en entrée une tension Vₑ continue entre des points A et B. La tension Vₑ peut notamment être délivrée par une source de tension. La commande rapprochée de convertisseurs délivre en sortie entre les points C et D une tension V_{Cde}. La tension V_{Cde} peut ensuite alimenter par exemple un convertisseur en pont ou tout autre convertisseur.

Un ensemble comportant notamment une diode D₁ et un interrupteur I₁ est positionné entre le point B et un point E. La diode D₁ et l'interrupteur I₁ sont placés en parallèle l'un par rapport à l'autre. L'anode de la diode D₁ est reliée au point B alors que la cathode de la diode D₁ est reliée au point E. L'interrupteur I₁ a une fonction de commande. L'interrupteur I₁ peut par exemple être un composant MOS ou tout autre composant jouant le rôle d'un interrupteur. La tension entre les points E et B est notée V_{DI1}.

Un ensemble comportant notamment une diode D₂ et un interrupteur I₂ est positionné entre le point B et un point F. La diode D₂ et l'interrupteur I₂ sont placés en parallèle l'un par rapport à l'autre. L'anode de la diode D₂ est reliée au point B alors que la cathode de la diode D₂ est reliée au point F. L'interrupteur I₂ peut par exemple être un composant MOS ou tout autre composant jouant le rôle d'un interrupteur. L'interrupteur I₂ a une fonction de commande. La tension entre les points F et B est notée V_{DI2}.

La commande rapprochée de convertisseurs selon l'invention comporte en outre un transformateur T₁. Le transformateur T₁ assure une fonction d'inductance couplée. Le transformateur T₁ peut être remplacé par n'importe quel composant adapté à cette fonction. Le transformateur T1 comporte notamment un enroulement primaire E₁ comportant un nombre N₁ de spires. L'enroulement primaire E₁ est relié entre le point A et un point G. Le transformateur T₁ comporte encore un enroulement primaire E₂ comportant un nombre N₁ de spires. L'enroulement primaire E₂ est relié entre le point A et le point F. Le transformateur T₁ comporte autant d'enroulements primaires que d'interrupteurs assurant une fonction de commande en phases ou en opposition de phases, à savoir deux enroulements primaires sur l'exemple de la figure 1. Le transformateur T₁ comporte aussi un enroulement secondaire E₃ comportant un nombre N₂ de spires. Le transformateur délivre une tension entre un point H et le point D. Le rapport de transformation m du transformateur T₁ est égale à N₂/N₁. Le transformateur T₁ comporte autant d'enroulements secondaires que d'interrupteurs à commander au moyen de la commande rapprochée.

Lorsque l'on souhaite un rapport cyclique différent de ½, le transformateur T₁ fonctionne avec un cycle d'aimantation non centré autour de 0, impliquant un début de saturation et un niveau de pertes fer plus élevé. Dans ce cas de figure, entre l'ensemble comportant notamment la diode D₁ et l'interrupteur I₁ et l'enroulement primaire E₁, c'est-à-dire entre les points E et F, on intercale un condensateur C₁. Le condensateur C₁ a notamment pour fonction d'autoriser le réglage du rapport cyclique au-delà ou en deçà de 50%. A titre d'exemple, le rapport cyclique peut être compris entre 30% et 70%. En régime établi, la charge de du condensateur C₁ permet d'assurer un cycle d'aimantation du transformateur T₁ symétrique autour de zéro et ainsi de ramener les pertes fer à leur plus faible niveau. La présence du condensateur C₁ permet de minimiser le volume du transformateur T₁ et de minimiser les pertes.

Dans un mode de réalisation, afin de minimiser les pertes, notamment liées aux résistances des interrupteurs I₁ et I₂, l'excursion en tension sur la tension V_{Cde} peut être limitée et la tension V_{Cde} décalée. Dans ce cas de figure un condensateur C₂ peut être positionné entre le point H et le point C. Le condensateur C2, en régime établi, se charge à la tension de décalage choisie. Cette tension est fonction des composants retenus. Une diode D3 peut être positionnée entre le point C et le point D. L'anode de la diode D₃ est reliée au point D alors que la cathode de la diode D₃ est reliée au point C. La diode D₃ permet de supprimer la composante négative. La valeur maximale de la tension V_{Cde} est notée V_{Cde max}. La tension directe V_{d} de la diode D₃ est choisie de façon à satisfaire l'équation suivante : V_{Cde max} = Vₑ.m - V_{d}.

Dans un autre mode de réalisation, la diode D₃ est une diode Zener. La diode D₃ permet alors de décaler la commande en positif ou en négatif.

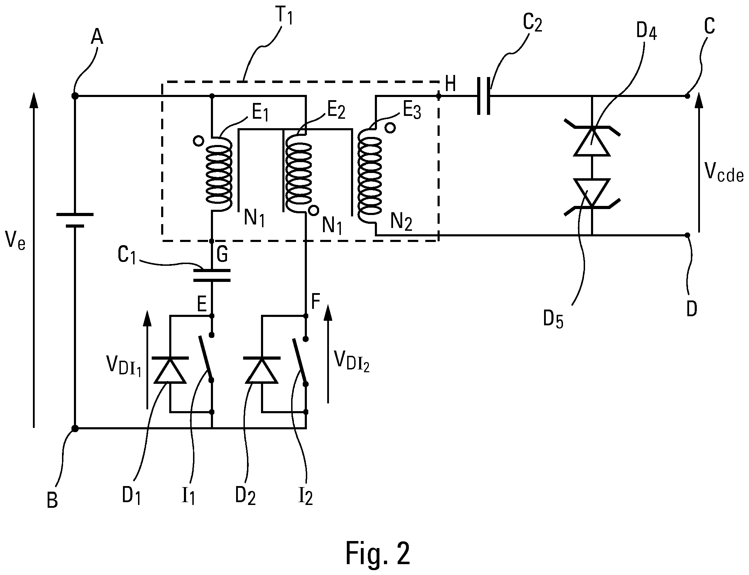

La figure 2 illustre un schéma de principe d'une commande rapprochée de convertisseurs selon un autre mode de réalisation de l'invention. Les éléments identiques aux éléments déjà présentés sur les autres figures portent les mêmes références. Dans un autre mode de réalisation de la commande rapprochée de convertisseurs selon l'invention, la diode D₃ présente sur le schéma de la figure 1 est remplacée par deux diodes Zener : une diode Zener D₄ et une diode Zener D₅. La cathode de la diode Zener D₄ est reliée au point C. L'anode de la diode D₄ est reliée à l'anode de la diode Zener D₅. La cathode de la diode Zener D₅ est reliée au point D.

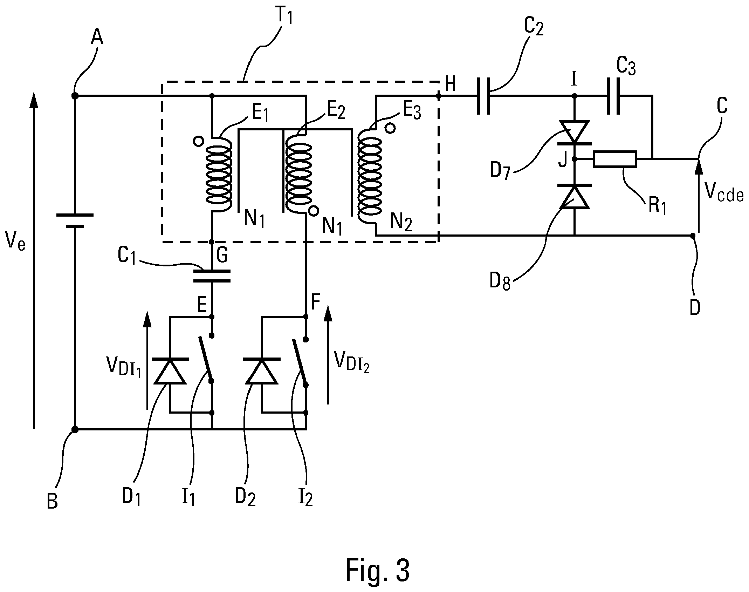

La figure 3 illustre un schéma de principe d'une commande rapprochée de convertisseurs selon un autre mode de réalisation de l'invention. Les éléments identiques aux éléments déjà présentés sur les autres figures portent les mêmes références. Dans un autre mode de réalisation de la commande rapprochée de convertisseurs selon l'invention, la diode D₃ présente sur le schéma de la figure 1 est supprimée. Le condensateur C₂ est relié entre le point H et un point I. Un condensateur C₃ est inséré entre les points I et C. Une diode D₇ est reliée entre le point I et un point J. L'anode de la diode D₇ est reliée au point I alors que la cathode de la diode D₇ est reliée au point J. Une résistance R₁ est reliée entre le point J et le point C. Une diode D₈ est reliée entre le point J et le point D. L'anode de la diode D₈ est reliée au point D alors que la cathode de la diode D₈ est reliée au point J.

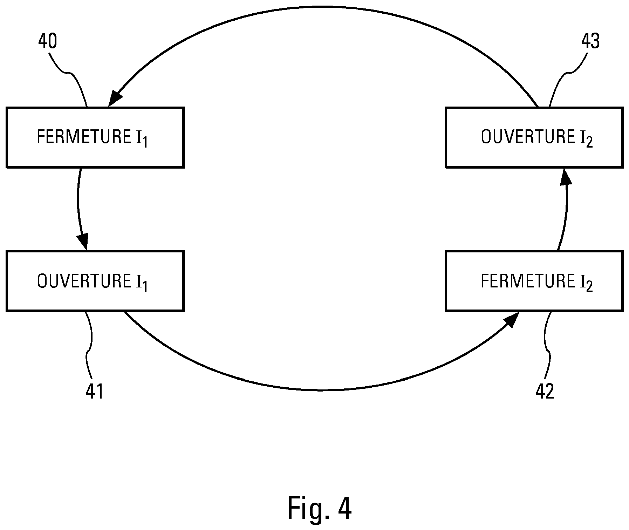

La figure 4 illustre la stratégie de commande des interrupteurs I₁ et I₂ selon l'invention. Les éléments identiques aux éléments déjà présentés sur les autres figures portent les mêmes références. La stratégie de commande des interrupteurs I₁ et I₂ comporte notamment quatre phases, qui peuvent être répétées cycliquement.

Dans une première étape 40, à un instant T₀, l'interrupteur I₁ est fermé. Puis dans une deuxième étape 41, à un instant T₁, on ouvre l'interrupteur I₁. La diode D₂ devient alors conducteur à un instant noté t₂. Avant que le courant qui parcourt la diode D₂ ne s'annule, l'interrupteur I₂ est fermé dans une étape 42. Puis, à un instant T₃, on ouvre l'interrupteur I₂ dans une étape 43. La diode D₁ devient alors conducteur à un instant noté T₄. On passe alors à nouveau à l'étape 40.

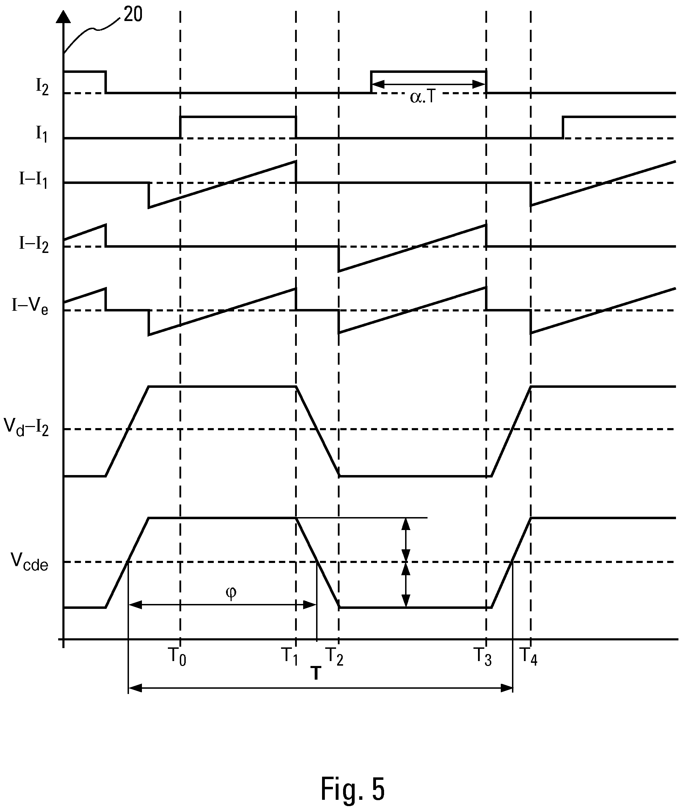

La figure 5 illustre par des chronogrammes et des formes d'ondes la stratégie de commande des interrupteurs I₁ et I₂ selon l'invention appliquée à une commande rapprochée de convertisseurs fonctionnant avec un rapport cyclique ½ selon l'invention. Les éléments identiques aux éléments déjà présentés sur les autres figures portent les mêmes références. L'axe 21 des abscisses représente le temps. La description du fonctionnement qui suit ne tient pas compte des condensateurs C₁ et C₂, le rapport cyclique étant dans l'exemple de la figure 4 rigoureusement égal à 0,5. Le courant qui circule dans l'ensemble comportant l'interrupteur I₁ et la diode D₁ est noté I_I₁. Le courant I_I₁ est fonction du temps. Le courant qui circule dans l'ensemble comportant l'interrupteur I₂ et la diode D₂ est noté I_I₂. Le courant I_I₂ est fonction du temps. Une courbe 10 représente le signal de commande reçu par l'interrupteur I₂ en fonction du temps. Une courbe 11 représente le signal de commande reçu par l'interrupteur I₁ en fonction du temps. Une courbe 12 représente le courant I_I₁ en fonction du temps. Une courbe 13 représente le courant N₂ en fonction du temps. Une courbe 14 représente le courant délivré par la source de tension entre les points A et B, noté I V_{E,} en fonction du temps. Une courbe 16 représente Ia tension V_{DI2.} Une courbe 17 représente la tension V_{Cde}.

A l'instant T₀, l'interrupteur I₁ est fermé dans l'étape 40 de la stratégie de commande des interrupteurs I₁ et I₂ selon l'invention. Si on note m le rapport N₁/N₂, la tension V_{Cde} est alors égale à Vₑ/m. La commutation de l'interrupteur I₁ est réalisée sans perte (ou selon l'expression anglo-saxonne en « Zéro Switching Voltage »). Le courant I_I1 croît alors de façon linéaire car une tension continue est appliquée aux bornes de l'inductance magnétisante du transformateur T₁.

A l'instant T₁, l'interrupteur I1 est ouvert dans l'étape 41 de la stratégie de commande des interrupteurs I₁ et I₂ selon l'invention. A cet instant, le courant I I₁ a atteint une valeur maximale notée I I₁ₘₐₓ. L'inductance magnétisante du transformateur T₁ résonne avec une capacité équivalente Cg. L'énergie stockée dans l'inductance magnétisante du transformateur T₁ est alors transférée à la capacité équivalente Cg. La tension V_{Cde} décroît alors jusqu'à atteindre la tension -Vₑ/m, ce qui provoque la mise en conduction de la diode D₂.

A l'instant T₂, en régime établi, aux pertes Joules prêt, le courant I_I₂ (t2) est égal à l'opposé du courant I_I₁ₘₐₓ. Le courant I_I₂ croît alors de façon linéaire car une tension continue est appliquée aux bornes de l'inductance magnétisante du transformateur T₁. L'interrupteur I₂ est fermé dans l'étape 42 de la stratégie de commande des interrupteurs I₁ et I₂ selon l'invention avant que le courant dans la diode D₂ ne s'annule. La diode D₂ conduisant, la tension aux bornes de l'interrupteur I₂ étant quasiment nulle, la commutation de I₂ est réalisée sans perte.

A l'instant T₃, l'interrupteur I₂ est ouvert dans l'étape 43 de la stratégie de commande des interrupteurs I₁ et I₂ selon l'invention. A cet instant T₃, le courant N₂ à atteint une valeur maximale notée I_I₂ₘₐₓ égale au courant I_I₁ₘₐₓ. L'inductance magnétisante du transformateur T₁ résonne avec la capacité équivalente Cg. L'énergie stockée dans l'inductance magnétisante du transformateur T₁ est alors transférée à la capacité équivalente Cg. La tension V_{Cde} croît alors jusqu'à atteindre la tension Vₑ/m, ce qui provoque la mise en conduction de la diode D₁.

A l'instant T₄ de mise en conduction de la diode D₁, en régime établi, aux pertes Joules prêt, le courant I_I₁ est égal à l'opposé du courant I_I₁ₘₐₓ. Le courant I_I₁ croît alors de façon linéaire car une tension continue est appliquée aux bornes de l'inductance magnétisante de T1. On peut alors, avant que le courant I_I1 (t) ne s'annule, recommencer l'étape 40 de la stratégie de commande des interrupteurs I₁ et I₂ selon l'invention.

## Revendications

1. Commande rapprochée délivrant une tension de commande (vide) à au moins un convertisseur d'énergie électrique, recevant une tension d'entrée (Vₑ) continue entre un point A et un point B, ladite commande comportant :
- une première diode (D₁) en parallèle d'un interrupteur (I₁), l'anode de la diode (D₁) étant reliée au point B, la cathode de ladite première diode (D₁) étant reliée à un point E ;
- une deuxième diode (D₂) en parallèle d'un interrupteur (I₂), l'anode de ladite deuxième diode (D₂) étant reliée au point B, la cathode de ladite deuxième diode (D₂) étant reliée à un point F ;
- un transformateur (T₁) comportant un premier enroulement primaire (E₁) relié entre le point A et un point G, un second enroulement primaire (E₂) relié entre le point A et le point F, et un enroulement secondaire (E₃), ledit transformateur (T₁) délivrant une tension entre un point H et un point D, ledit premier enroulement primaire (E₁) et ledit second enroulement primaire (E₂) ayant le même nombre de spires ;
le point E et le point G étant connectés électriquement, le point H et le point C étant connectés électriquement, **caractérisé en ce que** les interrupteurs (I₁, I₂) sont commandés en répétant cycliquement les étapes suivantes :
- à un instant T₀, l'interrupteur (I₁) est fermé (40) ;
- à un instant T₁, l'interrupteur (I₁) est ouvert (41) ;
- l'interrupteur (I₂) est fermé (42) avant que le courant qui parcourt la diode (D₂) ne s'annule ;
- à un instant T₃, l'interrupteur I₂ est ouvert (43)
- à l'instant T₄ où la diode (D₁) devient conducteur, on recommence à la première étape (40).

2. Commande rapprochée selon la revendication 1 **caractérisée en ce que** le point E est connecté au point G par un condensateur (C₁).

3. Commande rapprochée selon l'une des quelconques revendications précédentes **caractérisée en ce que** le point H est connecté au point C par un condensateur (C₂).

4. Commande rapprochée selon l'une des quelconques revendications précédentes **caractérisée en ce qu'**une diode (D₃) est connectée entre le point C et le point D, l'anode de ladite diode (D₃) étant reliée au point D, la cathode de ladite diode (D₃) étant reliée au point C.

5. Commande rapprochée selon l'une des quelconques revendications 1 à 3 **caractérisée en ce qu'**elle comporte une première diode Zener (D₄) et une seconde diode Zener (D₅), la cathode de la première diode Zener (D₄) étant reliée au point C, l'anode de la première diode Zener (D₄) étant reliée à l'anode de la seconde diode Zener (D₅), la cathode de la seconde diode Zener (D₅) étant reliée au point D.

6. Commande rapprochée selon l'une des quelconques revendications 1 à 3 **caractérisée en ce qu'**elle comporte un condensateur (C₂) relié entre le point H et un point I, un condensateur (C₃) relié entre un point I et un point C, une diode (D₇) reliée entre le point I et un point J, l'anode de ladite diode (D₇) étant reliée au point I, la cathode de ladite diode (D₇) étant reliée au point J, une résistance (R₁) reliée entre le point J et le point C, une diode (D₈) reliée entre le point J et le point D, l'anode de ladite diode (D₈) étant reliée au point D, la cathode de ladite diode (D₈) étant reliée au point J.

## Patentansprüche

1. Genaue Steuerung, die eine Steuerspannung (V_{Cde}) an wenigstens einen elektrischen Leistungswandler abgibt, der eine Eingangsgleichspannung (Vₑ) zwischen einem Punkt A und einem Punkt B empfängt, wobei die Steuerung Folgendes umfasst:
- eine erste Diode (D₁) parallel zu einem Schalter (I₁), wobei die Anode der Diode (D₁) mit dem Punkt B verbunden ist, wobei die Kathode der ersten Diode (D₁) mit einem Punkt E verbunden ist;
- eine zweite Diode (D₂) parallel zu einem Schalter (I₂), wobei die Anode der zweiten Diode (D₂) mit dem Punkt B verbunden ist, wobei die Kathode der zweiten Diode (D₂) mit einem Punkt F verbunden ist;
- einen Transformator (T₁), der eine zwischen dem Punkt A und einem Punkt G verbundene erste Primärwicklung (E₁), eine zwischen dem Punkt A und dem Punkt F verbundene zweite Primärwicklung (E₂) und eine Sekundärwicklung (E₃) umfasst, wobei der Transformator (T₁) eine Spannung zwischen einem Punkt H und einem Punkt D abgibt, wobei die erste Primärwicklung (E₁) und die zweite Primärwicklung (E₂) dieselbe Anzahl von Windungen haben;
wobei der Punkt E und der Punkt G elektrisch verbunden sind, wobei der Punkt H und der Punkt C elektrisch verbunden sind, **dadurch gekennzeichnet, dass** die Schalter (I₁, I₂) durch zyklisches Wiederholen der folgenden Schritte gesteuert werden;
- zu einem Zeitpunkt T₀ wird der Schalter (I₁) geschlossen (40);
- zu einem Zeitpunkt T₁ wird der Schalter (I₁) geöffnet (41);
- der Schalter (I₂) wird geschlossen (42), bevor der die Diode (D₂) durchfließende Strom zusammenbricht;
- zu einem Zeitpunkt T₃ wird der Schalter I₂ geöffnet (43);
- zum Zeitpunkt T₄, in dem die Diode (D₁) leitend wird, wird erneut mit dem ersten Schritt (40) begonnen.

2. Genaue Steuerung nach Anspruch 1, **dadurch gekennzeichnet, dass** der Punkt E mit dem Punkt G durch einen Kondensator (C₁) verbunden ist.

3. Genaue Steuerung nach einem der vorherigen Ansprüche, **dadurch gekennzeichnet, dass** der Punkt H mit dem Punkt C durch einen Kondensator (C₂) verbunden ist.

4. Genaue Steuerung nach einem der vorherigen Ansprüche, **dadurch gekennzeichnet, dass** eine Diode (D₃) zwischen dem Punkt C und dem Punkt D verbunden ist, wobei die Anode der Diode (D₃) mit dem Punkt D verbunden ist, wobei die Kathode der Diode (D₃) mit dem Punkt C verbunden ist.

5. Genaue Steuerung nach einem der Ansprüche 1 bis 3, **dadurch gekennzeichnet, dass** sie eine erste Zener-Diode (D₄) und eine zweite Zener-Diode (D₅) umfasst, wobei die Kathode der ersten Zener-Diode (D₄) mit dem Punkt C verbunden ist, die Anode der ersten Zener-Diode (D₄) mit der Anode der zweiten Zener-Diode (D₅) verbunden ist, wobei die Kathode der zweiten Zener-Diode (D₅) mit dem Punkt D verbunden ist.

6. Genaue Steuerung nach einem der Ansprüche 1 bis 3, **dadurch gekennzeichnet, dass** sie Folgendes umfasst: einen Kondensator (C₂), der zwischen dem Punkt H und einem Punkt I verbunden ist, einen Kondensator (C₃), der zwischen einem Punkt I und einem Punkt C verbunden ist, eine Diode (D₇), die zwischen dem Punkt I und einem Punkt J verbunden ist, wobei die Anode der Diode (D₇) mit dem Punkt I verbunden ist, wobei die Kathode der Diode (D₇) mit dem Punkt J verbunden ist, einen Widerstand (R₁), der zwischen dem Punkt J und dem Punkt C verbunden ist, eine Diode (D₈), die zwischen dem Punkt J und dem Punkt D verbunden ist, wobei die Anode der Diode (D₈) mit dem Punkt D verbunden ist, wobei die Kathode der Diode (D₈) mit dem Punkt J verbunden ist.

## Claims

1. Close control supplying a control voltage (V_{Cde}) to at least one electrical energy converter, receiving a direct-current input voltage (Vₑ) between a point A and a point B, the control comprising:
- a first diode (D₁) in parallel with a switch (I₁), the anode of the diode (D₁) being connected to the point B, the cathode of the first diode (D₁) being connected to a point E;
- a second diode (D₂) in parallel with a switch (I₂), the anode of the second diode (D₂) being connected to the point B, the cathode of the second diode (D₂) being connected to a point F;
- a transformer (T₁) which comprises a first primary winding (E₁) which is connected between the point A and a point G, a second primary winding (E₂) which is connected between the point A and the point F, and a secondary winding (E₃), the transformer (T₁) supplying a voltage between a point H and a point D, the first primary winding (E₁) and the second primary winding (E₂) having the same number of turns;
the point E and the point G being electrically connected, the point H and the point C being electrically connected, **characterised in that** the switches (I₁, I₂) are controlled by cyclically repeating the following steps:
- at a time T₀, the switch (I₁) is closed (40);
- at a time T₁, the switch (I₁) is opened (41);
- the switch (I₂) is closed (42) before the current which passes through the diode (D₂) is cancelled;
- at a time T₃, the switch (I₂) is opened (43);
- at the time T₄ at which the diode (D₁) becomes conductive, restarting with the first step (40).

2. Close control according to claim 1, **characterised in that** the point E is connected to the point G by means of a capacitor (C₁).

3. Close control according to either of the preceding claims, **characterised in that** the point H is connected to the point C by means of a capacitor (C₂).

4. Close control according to any one of the preceding claims, **characterised in that** a diode (D₃) is connected between the point C and the point D, the anode of the diode (D₃) being connected to the point D, the cathode of the diode (D₃) being connected to the point C.

5. Close control according to any one of claims 1 to 3, **characterised in that** it comprises a first Zener diode (D₄) and a second Zener diode (D₅), the cathode of the first Zener diode (D₄) being connected to the point C, the anode of the first Zener diode (D₄) being connected to the anode of the second Zener diode (D₅), the cathode of the second Zener diode (D₅) being connected to the point D.

6. Close control according to any one of claims 1 to 3, **characterised in that** it comprises a capacitor (C₂) which is connected between the point H and a point I, a capacitor (C₃) which is connected between a point I and a point C, a diode (D₇) which is connected between the point I and a point J, the anode of the diode (D₇) being connected to the point I, the cathode of the diode (D₇) being connected to the point J, a resistor (R₁) which is connected between the point J and the point C, a diode (D₈) which is connected between the point J and the point D, the anode of the diode (D₈) being connected to the point D, the cathode of the diode (D₈) being connected to the point J.
